(19) Europäisches Patentamt
European Patent Office
Office européen des brevets

(11) **EP 3 465 235 B1**

(12) **EUROPÄISCHE PATENTSCHRIFT**

(45) Veröffentlichungstag und Bekanntmachung des Hinweises auf die Patenterteilung:
**26.06.2024 Patentblatt 2024/26**

(21) Anmeldenummer: **17725594.0**

(22) Anmeldetag: **24.05.2017**

(51) Internationale Patentklassifikation (IPC):
***G01R 27/08*** *(2006.01)*     ***G01R 31/62*** *(2020.01)*
***G01R 31/72*** *(2020.01)*

(52) Gemeinsame Patentklassifikation (CPC):
**G01R 27/08; G01R 31/62; G01R 31/72**

(86) Internationale Anmeldenummer:
**PCT/EP2017/062569**

(87) Internationale Veröffentlichungsnummer:
**WO 2017/202927 (30.11.2017 Gazette 2017/48)**

(54) **VERFAHREN UND VORRICHTUNGEN ZUM BESTIMMEN VON WIDERSTÄNDEN IN MEHRPHASEN-TRANSFORMATOREN**

METHOD AND APPARATUSES FOR DETERMINING RESISTANCES IN MULTIPHASE TRANSFORMERS

PROCÉDÉ ET DISPOSITIFS POUR DÉTERMINER DES RÉSISTANCES DANS DES TRANSFORMATEURS POLYPHASÉS

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **25.05.2016 AT 504782016**

(43) Veröffentlichungstag der Anmeldung:
**10.04.2019 Patentblatt 2019/15**

(73) Patentinhaber: **Omicron electronics GmbH**
**6833 Klaus (AT)**

(72) Erfinder:
- **FLAX, Dirk**
  **6850 Dornbirn (AT)**
- **SAPETSCHNIG, René**
  **6900 Bregenz (AT)**

(74) Vertreter: **Kraus & Lederer PartGmbB**
**Thomas-Wimmer-Ring 15**
**80539 München (DE)**

(56) Entgegenhaltungen:
**EP-B1- 2 710 389     WO-A1-2015/183238**
**CN-A- 102 759 662     US-B1- 7 106 078**

**Beschreibung**

GEBIET DER ERFINDUNG

Die vorliegende Erfindung betrifft Verfahren und Vorrichtungen zum Bestimmen von Widerständen in Mehrphasen-Transformatoren, insbesondere Mehrphasen-Leistungstransformatoren zum Einsatz als Betriebsmittel in elektrischen Energieversorgungsnetzen.

HINTERGRUND DER ERFINDUNG

Transformatoren, insbesondere Leistungstransformatoren, dienen in elektrischen Energieversorgungsnetzen als Betriebsmittel zur Übertragung elektrischer Leistung zwischen Spannungsebenen. Im fehlerfreien Betrieb treten dabei nur sehr geringe Leistungsverluste auf, welche in Wärme umgesetzt werden. Fehlerbedingt erhöhte Leistungsverluste können jedoch zu einer Wärmefreisetzung führen, die den betreffenden Transformator gegebenenfalls zerstört und Betriebsstörungen nach sich zieht.

Eine Absicherung des Betriebs gegen solche Störfälle erfordert eine proaktive Fehlererkennung. Diese kann etwa darin bestehen, elektrische Widerstände, insbesondere Wicklungswiderstände, in einem abzusichernden Transformator zu bestimmen. Um etwa einen Widerstand einer bestimmten Wicklung zu ermitteln, wird ein Strom in dessen Anschlüsse eingeprägt und die sich zwischen den Anschlüssen einstellende Spannung erfasst. Der gesuchte Widerstand lässt sich sodann über das ohmsche Gesetz bestimmen.

Damit sind beispielsweise Wicklungsfehler identifizierbar, welche sich in veränderten Widerstandswerten zeigen und daher mit größeren Leistungsverlusten und einer erhöhten Wärmefreisetzung einhergehen. Beispiele für solche Wicklungsfehler sind Windungsschlüsse, also Überbrückung von Windungen innerhalb einer Wicklung, und Wicklungsunterbrechungen.

Insbesondere bei Mehrphasen-Transformatoren stellt die Widerstandsbestimmung einen nicht unerheblichen Zeitaufwand dar: Dieser setzt sich aus Komponenten für eine Stabilisierung des eingeprägten Stroms, für die Erfassung der sich einstellenden Spannung, für ein Weiterschalten eines gegebenenfalls vorhandenen Laststufenschalters auf eine nächste Stufe und für ein Entladen des Transformators zusammen. Dieser Zeitaufwand wiederholt sich für sämtliche Stufen des Laststufenschalters und für eine jede der mehreren Phasen. US7,106,078B1 sowie EP2710389B1 offenbaren ein Verfahren und eine Vorrichtung zum Testen von Widerständen in Mehrphasen-Transformatoren,

ZUSAMMENFASSUNG DER ERFINDUNG

Der vorliegenden Erfindung liegt somit die Aufgabe zugrunde, verbesserte Verfahren und entsprechend ausgestaltete Vorrichtungen bereitzustellen, mit deren Hilfe ein Zeitaufwand zum Bestimmen der Widerstände von Mehrphasen-Transformatoren verkürzt werden kann.

Diese Aufgabe wird erfindungsgemäß durch ein Verfahren gemäß Patentanspruch 1 sowie durch eine Vorrichtung gemäß Patentanspruch 9 gelöst. Die abhängigen Ansprüche definieren bevorzugte und vorteilhafte Ausführungsformen der Erfindung. Derartige Verfahren und Vorrichtungen verkürzen durch gleichzeitige Bestimmung mehrerer Widerstände den Zeitaufwand zum Bestimmen der Widerstände von Mehrphasen-Transformatoren. Zudem ist damit ein gegebenenfalls vorgesehener Durchführungswiderstand eines Neutralleiters in einer Sternschaltung bestimmbar.

Ein Verfahren zum Bestimmen von Widerständen in einer Spannungsebene eines Mehrphasen-Transformators, welche eine Wicklung je Phase des Mehrphasen-Transformators aufweist, nach einem Ausführungsbeispiel umfasst ein Einprägen eines jeweiligen ersten Stroms in die jeweilige Wicklung der mehreren Phasen; ein Erfassen einer durch die eingeprägten ersten Ströme hervorgerufenen jeweiligen ersten Spannung in den mehreren Phasen; ein Einprägen eines jeweiligen zweiten Stroms in die jeweilige Wicklung der mehreren Phasen, wobei sich in zumindest einer der mehreren Phasen der jeweilige eingeprägte zweite Strom von dem jeweiligen eingeprägten ersten Strom unterscheidet; ein Erfassen einer durch die eingeprägten zweiten Ströme hervorgerufenen jeweiligen zweiten Spannung in den mehreren Phasen, und ein Bestimmen der Widerstände in der Spannungsebene in Abhängigkeit von den eingeprägten ersten und zweiten Strömen und den erfassten ersten und zweiten Spannungen.

Unter Spannungsebene wird dabei insbesondere eine Oberspannungsseite oder eine Unterspannungsseite des Transformators verstanden. Die mehreren Phasen umfassen insbesondere drei Phasen (Drehstrohm). Die Widerstände sind insbesondere ohmsche Widerstände, und die Ströme bzw. Spannungen sind insbesondere Gleichströme bzw. Gleichspannungen. Prinzipiell funktioniert das Verfahren auch für Wechselströme und Wechselspannungen, was jedoch einen Übergang zu komplexen Impedanzen erfordert, um Phasenlagen zu berücksichtigen.

Das Bestimmen der Widerstände in der Spannungsebene kann ein Lösen eines Gleichungssystems umfassen, welches auf einer Netzwerkanalyse der Spannungsebene bei den eingeprägten ersten und zweiten Strömen der mehreren Phasen beruht.

Unter Netzwerkanalyse wird bevorzugt eine Beschreibung eines Zusammenhangs zwischen elektrischen Strömen und elektrischen Spannungen in elektrischen Netzwerken mittels Kirchhoffscher Gesetze (Knotenregel, Maschenregel) und ein Lösen des Zusammenhangs nach gesuchten Größen verstanden.

Das Erfassen der durch die eingeprägten Ströme hervorgerufenen jeweiligen Spannung in den mehreren Phasen kann ein Erfassen der hervorgerufenen jeweiligen Spannung zwischen jeweiligen ersten und zweiten Anschlüssen der jeweiligen Wickung in den mehreren Phasen umfassen.

Die Spannungsebene kann eine Sternschaltung der mehreren Wicklungen umfassen, wobei die ersten Anschlüsse der mehreren Wicklungen mit einem Neutralleiter verbunden sind.

Die Spannungsebene kann eine Sternschaltung der mehreren Wicklungen umfassen, wobei die ersten Anschlüsse der mehreren Wicklungen über einen Durchführungswiderstand mit einem Neutralleiter verbunden sind.

Die bestimmten Widerstände können den Durchführungswiderstand umfassen.

Die Spannungsebene kann eine Dreiecksschaltung der mehreren Wicklungen umfassen.

Insbesondere ist in einer Dreiecksschaltung ein jeder der ersten Anschlüsse mit jeweils einem der zweiten Anschlüsse so verbunden, dass sich eine in sich geschlossene Reihenschaltung der Wicklungen der mehreren Phasen ergibt.

Die bestimmten Widerstände können die Widerstände der mehreren Wicklungen umfassen.

Eine Vorrichtung zum Bestimmen von Widerständen in einer Spannungsebene eines Mehrphasen-Transformators, welche eine Wicklung je Phase des Mehrphasen-Transformators aufweist, nach einem Ausführungsbeispiel umfasst eine Stromquelle, welche dazu eingerichtet ist, einen jeweiligen ersten und zweiten Strom in die jeweilige Wicklung der mehreren Phasen einzuprägen, wobei sich in zumindest einer der mehreren Phasen der jeweilige eingeprägte zweite Strom von dem jeweiligen eingeprägten ersten Strom unterscheidet; eine Erfassungseinrichtung, welche dazu eingerichtet ist, eine durch die eingeprägten ersten oder zweiten Ströme hervorgerufene jeweilige erste oder zweite Spannung in den mehreren Phasen zu erfassen; und eine Bestimmungseinrichtung, welche dazu eingerichtet ist, die Widerstände in der Spannungsebene in Abhängigkeit von den eingeprägten ersten und zweiten Strömen und den erfassten ersten und zweiten Spannungen zu bestimmen.

Die Bestimmungseinrichtung kann ein Rechnersystem sein.

Die Vorrichtung kann ferner eine Steuereinrichtung aufweisen, welche zur vollautomatischen Bestimmung der Widerstände ausgestaltet ist.

Vorteilhafterweise trägt die vollautomatische Bestimmung der Widerstände dazu bei, eine Zeitdauer zum Bestimmen der Widerstände von Mehrphasen-Transformatoren zu verkürzen.

Die Bestimmungseinrichtung kann die Steuereinrichtung umfassen.

Vorteilhafterweise kann dadurch die Zahl der Bauteil gesenkt und eine Miniaturisierung der Vorrichtung unterstützt werden.

Die Steuereinrichtung kann zur automatischen Ansteuerung der Stromquelle und der Erfassungseinrichtung ausgestaltet sein.

Vorteilhafterweise wird dabei durch den Ausschluss manueller Bedienvorgänge und entsprechender Fehlermöglichkeiten der Zeitaufwand zum Bestimmen der Widerstände von Mehrphasen-Transformatoren weiter verkürzt.

Die Vorrichtung kann tragbar ausgestaltet sein.

Vorteilhafterweise ermöglicht die tragbare Ausgestaltung, das Bestimmen der Widerstände am Einsatzort des Mehrphasen-Transformators durchzuführen.

KURZE BESCHREIBUNG DER FIGUREN

Die Erfindung wird nachfolgend anhand bevorzugter Ausführungsformen und unter Bezugnahme auf die Zeichnungen näher erläutert, wobei gleiche Bezugszeichen gleiche oder ähnliche Elemente bezeichnen.

Fig. 1 zeigt eine schematische Ansicht eines Mehrphasen-Transformators gemäß einem Ausführungsbeispiel;

Fig. 2 zeigt eine schematische Ansicht einer Sternschaltung gemäß einem ersten Ausführungsbeispiel;

Fig. 3 zeigt eine schematische Ansicht einer Sternschaltung gemäß einem zweiten Ausführungsbeispiel;

Fig. 4 zeigt eine schematische Ansicht einer Sternschaltung gemäß einem dritten Ausführungsbeispiel;

Fig. 5 zeigt eine schematische Ansicht einer Dreiecksschaltung gemäß einem Ausführungsbeispiel;

Fig. 6 zeigt ein Flussdiagramm eines Verfahrens gemäß einer Ausführungsform;

Fig. 7 zeigt ein schematisches Blockschaltbild einer Vorrichtung gemäß einer ersten Ausführungsform; und

Fig. 8 zeigt ein schematisches Blockschaltbild einer Vorrichtung gemäß einer zweiten Ausführungsform.

DETAILLIERTE BESCHREIBUNG VON AUSFÜHRUNGSBEISPIELEN

Nachfolgend wird die vorliegende Erfindung anhand bevorzugter Ausführungsformen und unter Bezugnahme auf die Zeichnungen näher erläutert.

Die Figuren sind schematische Darstellungen verschiedener Ausführungsformen der Erfindung. In den Figuren dargestellte Elemente sind nicht notwendigerweise maßstabsgetreu dargestellt, sondern vielmehr derart wiedergegeben, dass ihre Funktion und ihr Zweck dem Fachmann verständlich werden.

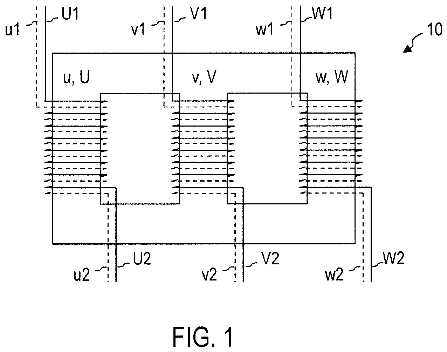

Fig. 1 zeigt eine schematische Ansicht eines Mehrphasen-Transformators 10 gemäß einem Ausführungsbeispiel.

Der Mehrphasen-Transformator 10 weist eine Dreischenkelausführung, das heißt drei Phasen, und zwei Spannungsebenen auf. Ein jeder der drei Schenkel umfasst jeweils eine Wicklung u, v, w einer Unterspannungsseite sowie eine Wicklung U, V, W einer Oberspannungsseite. Die Wicklungen u, v, w der Unterspannungsseite weisen erste und zweite Anschlüsse $u_1$, $u_2$, $v_1$, $v_2$, $w_1$, $w_2$ auf, wohingegen die Wicklungen U, V, W der Oberspannungsseite über erste und zweite Anschlüsse $U_1$, $U_2$, $V_1$, $V_2$, $W_1$, $W_2$ verfügen.

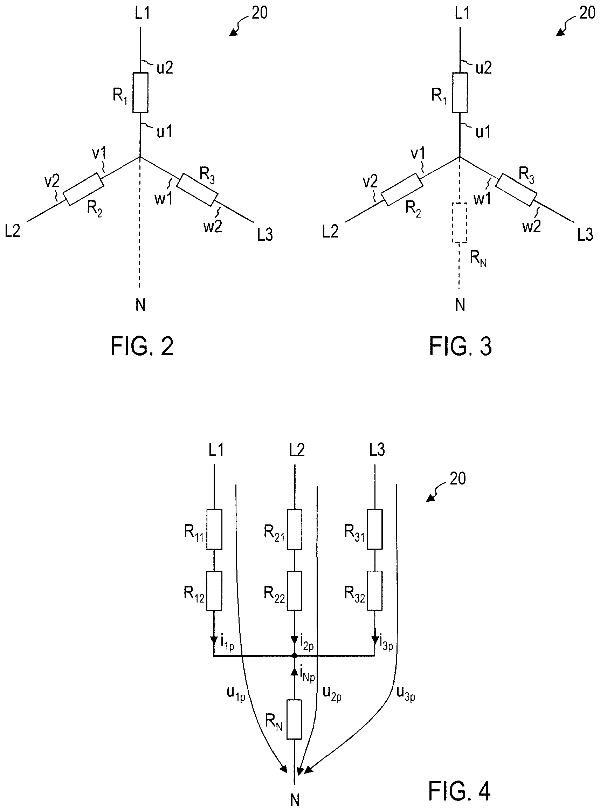

Fig. 2 zeigt eine schematische Ansicht einer Sternschaltung 20 gemäß einem ersten Ausführungsbeispiel.

Der zugrunde liegende Mehrphasen-Transformator 10 weist drei Phasen auf.

Ohne Einschränkung der Allgemeinheit sind in dem Ausführungsbeispiel die ersten Anschlüsse $u_1$, $v_1$, $w_1$ der Wicklungen u, v, w der Unterspannungsseite in einem Sternpunkt miteinander verbunden. Der Sternpunkt ist mit einem Neutralleiter N verknüpft, und die zweiten Anschlüsse $u_2$, $v_2$, $w_2$ der Wicklungen u, v, w der Unterspannungsseite sind an Außenleiter $L_1$, $L_2$, $L_3$ angebunden. Der Neutralleiteranschluss ist gestrichelt dargestellt, weil er bei symmetrischer Last nicht unbedingt erforderlich ist.

Die auf der in Fig. 2 dargestellten Unterspannungsseite vorgesehenen Wicklungswiderstände $R_1$, $R_2$, $R_3$ sind mit erfindungsgemäßen Verfahren und Vorrichtungen bestimmbar. Vergleichbares ist für entsprechend verschaltete Oberspannungsseiten zutreffend.

Fig. 3 zeigt eine schematische Ansicht einer Sternschaltung 20 gemäß einem zweiten Ausführungsbeispiel.

Abweichend von der ansonsten identischen Darstellung in Fig. 2 weist der Anschluss des Sternpunkts an den Neutralleiter N einen Durchführungswiderstand $R_N$ auf, welcher sich in Leistungsverlusten und entsprechender Wärmeentwicklung äußern kann.

Mit erfindungsgemäßen Verfahren und Vorrichtungen sind sowohl die Wicklungswiderstände $R_1$, $R_2$, $R_3$ als auch der Durchführungswiderstand $R_N$ bestimmbar. Analoges gilt für entsprechend verschaltete Oberspannungsseiten.

Fig. 4 zeigt eine schematische Ansicht einer Sternschaltung 20 gemäß einem dritten Ausführungsbeispiel.

In dem Ausführungsbeispiel ist der Durchführungswiderstand $R_N$ des Neutralleiters N fest vorgesehen. Im Unterschied zur Fig. 3 ist in einem jeden der drei Außenleiter $L_1$, $L_2$, $L_3$ neben dem Wicklungswiderstand $R_{12}$, $R_{22}$, $R_{32}$ ferner ein jeweiliger Durchführungswiderstand $R_{11}$, $R_{21}$, $R_{31}$ mit berücksichtigt. Mit dem erfindungsgemäßen Verfahren ist dabei für einen jeden der drei Außenleiter $L_1$, $L_2$, $L_3$ die jeweilige Summe $R_1$, $R_2$, $R_3$ aus Durchführungswiderstand $R_{11}$, $R_{21}$, $R_{31}$ und Wicklungswiderstand $R_{12}$, $R_{22}$, $R_{32}$ ermittelbar, wie im Folgenden anhand eines Berechnungsbeispiels gezeigt wird.

Gemäß dem ersten Kirchhoffschen Gesetz (Knotenregel) ergibt sich dort, wo die drei Außenleiter $L_1$, $L_2$, $L_3$ zusammentreffen, eine Nullsumme der Ströme:

$$i_{1p} + i_{2p} + i_{3p} + i_{Np} = 0 \qquad\qquad \text{mit } p \in \{1; 2\}$$

Der Index p erfasst dabei, ob es sich um die ersten (p=1) oder zweiten (p=2) Ströme (bzw. nachfolgend auch Spannungen) handelt. Der Neutralleiter N nimmt stets die Summe $i_{Np}$ der eingeprägten Ströme $i_{1p}$, $i_{2p}$, $i_{3p}$ auf. Auch ohne Erfassung der Ströme $i_{Np}$ im Neutralleiter N sind demnach alle Ströme bekannt.

Aus dem zweiten Kirchhoffschen Gesetz (Maschenregel) und dem Ohmschen Gesetz ergibt sich für die Strangspannungen $u_{1p}$, $u_{2p}$, $u_{3p}$ der drei Außenleiter $L_1$, $L_2$, $L_3$:

$$u_{1p} = i_{1p}\cdot R_1 - i_{Np}\cdot R_N \qquad\qquad \text{(I)}$$

$$u_{2p} = i_{2p}\cdot R_2 - i_{Np}\cdot R_N \qquad\qquad \text{(II)}$$

$$u_{3p} = i_{3p} \cdot R_3 - i_{Np} \cdot R_N \qquad\qquad \text{(III)} \qquad \text{mit } p \in \{1; 2\}$$

Ausgeschrieben ergeben sich drei Gleichungssysteme mit jeweils zwei Gleichungen und zwei Unbekannten, die getrennt voneinander lösbar sind:

$$i_{11} \cdot R_1 \qquad\qquad - i_{N1} \cdot R_N \quad = u_{11} \qquad\qquad \text{(I')}$$

$$i_{12} \cdot R_1 \qquad\qquad - i_{N2} \cdot R_N \quad = u_{12} \qquad\qquad \text{(I'')}$$

$$i_{21} \cdot R_2 \qquad - i_{N1} \cdot R_N \quad = u_{21} \qquad\qquad \text{(II')}$$

$$i_{22} \cdot R_2 \qquad - i_{N2} \cdot R_N \quad = u_{22} \qquad\qquad \text{(II'')}$$

$$i_{31} \cdot R_3 \quad - i_{N1} \cdot R_N \quad = u_{31} \qquad\qquad \text{(III')}$$

$$i_{32} \cdot R_3 \quad - i_{N2} \cdot R_N \quad = u_{32} \qquad\qquad \text{(III'')}$$

Nachfolgend werden ihre beiden Gleichungen beispielhaft so skaliert und addiert, dass jeweils der Durchführungswiderstand $R_N$ des Neutralleiters N herausfällt und sich einer der gesuchten Widerstände $R_1$, $R_2$, $R_3$ ergibt:

$$R_1 = [u_{11} + i_{N1}/(-i_{N2}) \cdot u_{12}] / [i_{11} + i_{N1}/(-i_{N2}) \cdot i_{12}] \qquad \text{aus (I')} + i_{N1}/(-i_{N2}) \cdot \text{(I'')}$$

$$R_2 = [u_{21} + i_{N1}/(-i_{N2}) \cdot u_{22}] / [i_{21} + i_{N1}/(-i_{N2}) \cdot i_{22}] \qquad \text{aus (II')} + i_{N1}/(-i_{N2}) \cdot \text{(II'')}$$

$$R_3 = [u_{31} + i_{N1}/(-i_{N2}) \cdot u_{32}] / [i_{31} + i_{N1}/(-i_{N2}) \cdot i_{32}] \qquad \text{aus (III')} + i_{N1}/(-i_{N2}) \cdot \text{(III'')}$$

Den ebenfalls gesuchte Durchführungswiderstand $R_N$ des Neutralleiters N liefert eine beliebige Gleichung der drei Gleichungssysteme durch Einsetzen:

$$R_N = \{u_{11} - i_{11} \cdot R_1\} / (- i_{N1}) = \qquad\qquad \text{aus (I')}$$

$$= \{u_{11} - i_{11} \cdot [u_{11} + i_{N1}/(-i_{N2}) \cdot u_{12}] / [i_{11} + i_{N1}/(-i_{N2}) \cdot i_{12}]\} / (- i_{N1})$$

Somit sind sämtliche Widerstände $R_1$, $R_2$, $R_3$, $R_N$ in der Spannungsebene in Abhängigkeit von den eingeprägten ersten und zweiten Strömen $i_{1p}$, $i_{2p}$, $i_{3p}$, $i_{Np}$ und den erfassten ersten und zweiten Spannungen $u_{1P}$, $u_{2p}$, $u_{3p}$ bestimmt, wobei $p \in \{1; 2\}$.

Es genügen bereits geringe Unterschiede zwischen den eingeprägten Strömen, um lösbare Gleichungen hervorzubringen, etwa:

$$i_{11} = +I, \quad i_{21} = +I, \quad i_{31} = -I,$$

und

$$i_{12} = +I, \quad i_{22} = +I, \quad i_{32} = -0{,}9 \cdot I,$$

wobei I ein Strom mit einer definierten Stärke in Ampere ist.

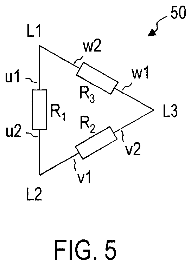

Fig. 5 zeigt eine schematische Ansicht einer Dreiecksschaltung 50 gemäß einem Ausführungsbeispiel.

Eine solche Schaltgruppe kann etwa in einem Mehrphasen-Transformator 10 mit drei Phasen vorliegen.

Wiederum ist ohne Einschränkung der Allgemeinheit die Unterspannungsseite abgebildet. Anschlusspaare $u_1$-$w_2$, $v_1$-$u_2$ und $w_1$-$v_2$ der Wicklungen u, v, w der Unterspannungsseite verknüpfen die Wicklungen u, v, w zu einer in sich geschlossenen Reihenschaltung. Die Verbindungspunkte der Anschlusspaare $u_1$-$w_2$, $v_1$-$u_2$ und $w_1$-$v_2$ der Wicklungen u, v, w sind an Außenleiter $L_1$, $L_2$, $L_3$ angebunden.

Auch auf der in Fig. 5 dargestellten Spannungsebene sind die Wicklungswiderstände $R_1$, $R_2$, $R_3$ in ähnlicher Weise einer Bestimmung zugänglich wie dies zuvor für Fig. 4 gezeigt wurde. Für entsprechend verschaltete Oberspannungsseiten gilt Vergleichbares.

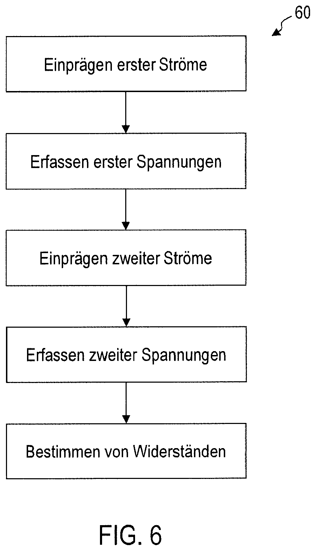

Fig. 6 zeigt ein Flussdiagramm eines Verfahrens 60 gemäß einer Ausführungsform.

Das Verfahren bezieht sich auf eine Spannungsebene des Mehrphasen-Transformators 10, also entweder auf die Unterspannungsseite oder die Oberspannungsseite desselben, welche eine Wicklung je Phase umfasst.

In einem ersten Schritt erfolgt ein Einprägen erster Ströme in die Wicklungen der Spannungsebene. Hierzu wird eine zuvor bereitgestellte Nutzereingabe für die einzuprägenden ersten Ströme mit einer ebenfalls zuvor bereitgestellte Nutzereingabe für normgemäße Maximalströme abgeglichen und als Zielwert für ein sequentielles Hochfahren der einzuprägenden ersten Ströme bis zu dem Zielwert eingesetzt. Bei einer Sternschaltung ohne Neutralleiteranschluss des Sternpunkts sowie bei einer Dreiecksschaltung stehen den drei Anschlüssen $L_1$, $L_2$, $L_3$ zwei vorzugebende Ströme gegenüber. Bei einer Sternschaltung mit Neutralleiteranschluss des Sternpunkts sind den vier Anschlüssen $L_1$, $L_2$, $L_3$, N hingegen drei Ströme einzuprägen. Der Zielwert ist erreicht und der erste Schritt ist vollzogen, wenn ein Stabilitätskriterium erfüllt ist.

In einem zweiten Schritt werden durch die eingeprägten ersten Ströme hervorgerufene erste Spannungen in den mehreren Phasen der Spannungsebene erfasst. Zu diesem Zweck werden die hervorgerufenen Spannungen zwischen jeweiligen ersten und zweiten Anschlüssen der jeweiligen Wickung in den mehreren Phasen gemessen.

Dies erfolgt insbesondere zeitgleich. In einer Sternschaltung ohne Neutralleiteranschluss des Sternpunkts sowie in einer Dreiecksschaltung sind dies die Spannungen zwischen den Anschlusspaaren $L_1$-$L_2$, $L_2$-$L_3$ und $L_3$-$L_1$. In einer Sternschaltung mit Neutralleiteranschluss des Sternpunkts werden die Spannungen zwischen den Anschlusspaaren $L_1$-N, $L_2$-N und $L_3$-N gemessen.

In einem dritten Schritt werden zweite Ströme in die Wicklungen der Spannungsebene eingeprägt. Für die Zahl der einzuprägenden Ströme wird auf die vorhergehenden Ausführungen bezüglich des ersten Schritts verwiesen. Zumindest einer der eingeprägten zweiten Ströme muss dabei jedoch von seinem entsprechenden eingeprägten ersten Strom verschieden sein.

In einem vierten Schritt werden die durch die eingeprägten zweiten Ströme hervorgerufenen zweiten Spannungen in den mehreren Phasen der Spannungsebene erfasst.

Die zweiten Spannungen werden zwischen denselben Anschlüssen zeitgleich gemessen wie dies bereits beim zweiten Schritt beschrieben wurde. Am Ende des vierten Schritts erfolgt ein sequentielles Herunterfahren der einzuprägenden zweiten Ströme bis zu dem Zielwert Null.

In einem fünften Schritt werden die Widerstände in der Spannungsebene in Abhängigkeit von den eingeprägten ersten und zweiten Strömen und den erfassten ersten und zweiten Spannungen bestimmt. Ein jeder der beiden zuvor beschriebenen Erfassungsschritte trägt hierzu einen Satz von Gleichungen bei, welcher auf einer Netzwerkanalyse der Spannungsebene bei den eingeprägten ersten oder zweiten Strömen beruht. Die Gleichungen basieren auf den Kirchhoffschen Knoten- und Maschenregeln, in welchen die jeweils eingeprägten Ströme mit den jeweils erfassten Spannungen gemäß der der zu bestimmenden Widerstände und der Schaltungstopologie der Spannungsebene verknüpft sind. Die Widerstände in der Spannungsebene sind demzufolge durch Lösung des Gleichungssystems mittels bekannter Methoden bestimmbar. Die auf diese Art und Weise bestimmbaren Widerstände umfassen ganz allgemein die Wicklungswiderstände $R_1$, $R_2$, $R_3$. In einer Sternschaltung mit Durchführungswiderstand $R_N$ von dem Sternpunkts zu dem Neutralleiter N ist auch der Durchführungswiderstand $R_N$ bestimmbar.

Falls der Transformator über Laststufenschalter verfügt, so ist das Verfahren für eine jede Laststufe eines jeden der Laststufenschalter wiederholbar.

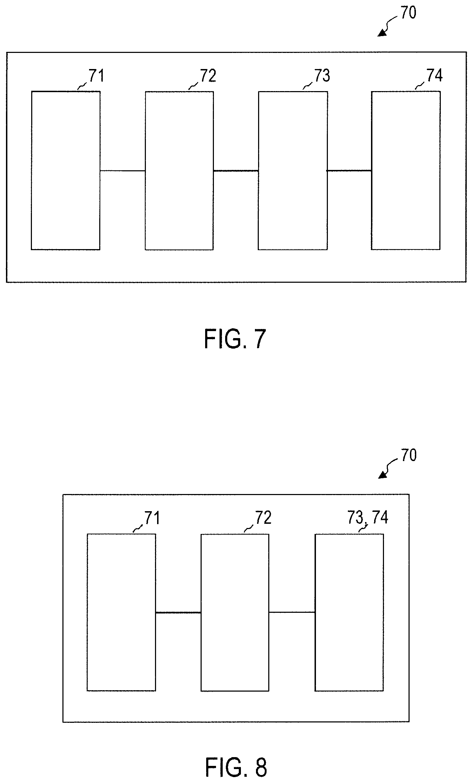

Fig. 7 zeigt ein schematisches Blockschaltbild einer Vorrichtung 70 gemäß einer ersten Ausführungsform.

Auch die Vorrichtung 70 betrachtet eine Spannungsebene des Mehrphasen-Transformators 10. Sie umfasst eine Stromquelle 71, eine Erfassungseinrichtung 72 und eine Bestimmungseinrichtung 73.

Die Stromquelle 71 dient dazu, die ersten oder zweiten Ströme in die jeweiligen Wicklungen u, v, w oder U, V, W einzuprägen, je nachdem, ob die Spannungsebene eine Unterspannungsseite oder Oberspannungsseite des Transformators ist. Entsprechend dem oben gesagten müssen sich die eingeprägten ersten und zweiten Ströme zumindest hinsichtlich eines Stroms unterscheiden, um voneinander unabhängige Sätze von Gleichungen bereitzustellen.

Die Erfassungseinrichtung 72 ist zum Erfassen der durch die eingeprägten ersten oder zweiten Ströme hervorgerufenen ersten oder zweiten Spannungen zwischen zuvor beschriebenen Anschlusspaaren eingerichtet.

Die Bestimmungseinrichtung 73 ist dazu ausgestaltet, die bis zu vier Widerstände $R_1$, $R_2$, $R_3$, $R_N$ in der Spannungsebene in Abhängigkeit von den eingeprägten ersten und zweiten Strömen und den erfassten ersten und zweiten Spannungen zu bestimmen. Sie kann ein Rechnersystem sein, welches maschinenlesbare Anweisungen ausführen kann.

Die in Fig. 7 gezeigte Vorrichtung 70 weist ferner eine Steuereinrichtung 74 auf, welche zur vollautomatischen Durchführung des Verfahrens 60 ausgestaltet ist, indem sie die Stromquelle 71, die Erfassungseinrichtung 72 und die Bestimmungseinrichtung 73 nach Bereitstellung erforderlicher elektrischer Kontakte zwischen der Vorrichtung 70 und den bis zu vier Anschlüssen $L_1$, $L_2$, $L_3$, N des Mehrphasen-Transformators dem Ablauf des Verfahrens 60 entsprechend ansteuert.

Fig. 8 zeigt ein schematisches Blockschaltbild einer Vorrichtung 70 gemäß einer zweiten Ausführungsform.

Demgemäß sind die Bestimmungseinrichtung 73 und die Steuereinrichtung 74 integriert ausgestaltet. Hinsichtlich der sonstigen Ausgestaltung und der Funktionsweise der Vorrichtung 70 aus Fig. 8 kann zur Vermeidung von Wiederholungen auf die vorhergehenden Ausführungen zu Fig. 7 verwiesen werden.

Im Übrigen können die Vorrichtungen 70 aus den Fig. 7 - 8 tragbar ausgestaltet sein.

BEZUGSZEICHEN

| | |
|---|---|
| 10 | Mehrphasen-Transformator |
| 20 | Sternschaltung |
| 50 | Dreiecksschaltung |
| 60 | Verfahren |
| 70 | Vorrichtung |
| 71 | Stromquelle |
| 72 | Erfassungseinrichtung |
| 73 | Bestimmungseinrichtung |
| 74 | Steuereinrichtung |
| u, v, w | Wicklungen der mehreren Phasen der Unterspannungseite des Mehrphasen-Transformators |
| $u_1$, $v_1$, $w_1$ | erste Anschlüsse derselben |
| $u_2$, $v_2$, $w_2$ | zweite Anschlüsse derselben |
| U, V, W | Wicklungen der mehreren Phasen der Oberspannungseite des Mehrphasen-Transformators |
| $U_1$, $V_1$, $W_1$ | erste Anschlüsse derselben |
| $U_2$, $V_2$, $W_2$ | zweite Anschlüsse derselben |
| $L_1$, $L_2$, $L_3$ | Außenleiter |
| N | Neutralleiter |
| $R_1$, $R_2$, $R_3$ | Wicklungswiderstände |
| $R_N$ | Durchführungswiderstand |

**Patentansprüche**

1. Verfahren (60) zum Bestimmen von Widerständen ($R_1$, $R_2$, $R_3$, $R_N$) in einer Spannungsebene eines Mehrphasen-Transformators (10), wobei die Spannungsebene eine Wicklung (u, v, w; U, V, W) je Phase des Mehrphasen-Transformators (10) aufweist, umfassend:

   - Einprägen eines jeweiligen ersten Stroms in die jeweilige Wicklung (u, v, w; U, V, W) der mehreren Phasen,
   - gleichzeitiges Erfassen einer durch die eingeprägten ersten Ströme hervorgerufenen jeweiligen ersten Spannung in den mehreren Phasen,
   - Einprägen eines jeweiligen zweiten Stroms in die jeweilige Wicklung (u, v, w; U, V, W) der mehreren Phasen, wobei sich in zumindest einer der mehreren Phasen der jeweilige eingeprägte zweite Strom von dem jeweiligen eingeprägten ersten Strom unterscheidet,
   - gleichzeitiges Erfassen einer durch die eingeprägten zweiten Ströme hervorgerufenen jeweiligen zweiten Spannung in den mehreren Phasen, und
   - gleichzeitiges Bestimmen von mehreren Widerständen ($R_1$, $R_2$, $R_3$, $R_N$) in der Spannungsebene des Mehrphasen-Transformators (10) in Abhängigkeit von den eingeprägten ersten Strömen und den eingeprägten zweiten Strömen sowie den erfassten ersten Spannungen und den erfassten zweiten Spannungen, wobei die gleichzeitig bestimmten mehreren Widerstände ($R_1$, $R_2$, $R_3$, $R_N$) des Mehrphasen-Transformators (10) Widerstände

($R_1$, $R_2$, $R_3$) der einzelnen Phasen des Mehrphasen-Transformators (10) umfassen.

2. Verfahren (60) gemäß Anspruch 1, wobei das Bestimmen der mehreren Widerstände ($R_1$, $R_2$, $R_3$, $R_N$) in der Spannungsebene ein Lösen eines Gleichungssystems umfasst, welches auf einer Netzwerkanalyse der Spannungsebene bei den eingeprägten ersten und zweiten Strömen der mehreren Phasen beruht.

3. Verfahren (60) gemäß Anspruch 1 oder 2, wobei das Erfassen der durch die eingeprägten Ströme hervorgerufenen jeweiligen Spannung in den mehreren Phasen ein Erfassen der hervorgerufenen jeweiligen Spannung zwischen jeweiligen ersten ($u_1$, $v_1$, $w_1$; $U_1$, $V_1$, $W_1$) und zweiten Anschlüssen ($u_2$, $v_2$, $w_2$; $U_2$, $V_2$, $W_2$) der jeweiligen Wicklung in den mehreren Phasen umfasst.

4. Verfahren (60) gemäß Anspruch 3, wobei die Spannungsebene eine Sternschaltung (20) der mehreren Wicklungen ($u$, $v$, $w$; $U$, $V$, $W$) umfasst, wobei die ersten Anschlüsse ($u_1$, $v_1$, $w_1$; $U_1$, $V_1$, $W_1$) der mehreren Wicklungen ($u$, $v$, $w$; $U$, $V$, $W$) mit einem Neutralleiter (N) verbunden sind.

5. Verfahren (60) gemäß Anspruch 3, wobei die Spannungsebene eine Sternschaltung (20) der mehreren Wicklungen ($u$, $v$, $w$; $U$, $V$, $W$) umfasst, wobei die ersten Anschlüsse ($u_1$, $v_1$, $w_1$; $U_1$, $V_1$, $W_1$) der mehreren Wicklungen ($u$, $v$, $w$; $U$, $V$, $W$) über einen Durchführungswiderstand ($R_N$) mit einem Neutralleiter (N) verbunden sind.

6. Verfahren (60) gemäß Anspruch 5, wobei die mehreren bestimmten Widerstände den Durchführungswiderstand ($R_N$) umfassen.

7. Verfahren (60) gemäß Anspruch 3, wobei die Spannungsebene eine Dreiecksschaltung (50) der mehreren Wicklungen ($u$, $v$, $w$; $U$, $V$, $W$) umfasst.

8. Verfahren (60) gemäß einem der vorhergehenden Ansprüche, wobei die bestimmten mehreren Widerstände die Widerstände ($R_1$, $R_2$, $R_3$) der mehreren Wicklungen ($u$, $v$, $w$; $U$, $V$, $W$) der einzelnen Phasen des Mehrphasen-Transformators (10) umfassen.

9. Vorrichtung (70) zum Bestimmen von Widerständen ($R_1$, $R_2$, $R_3$, $R_N$) in einer Spannungsebene eines Mehrphasen-Transformators (10), wobei die Spannungsebene eine Wicklung ($u$, $v$, $w$; $U$, $V$, $W$) je Phase des Mehrphasen-Transformators (10) aufweist, umfassend:

   - eine Stromquelle (71), welche dazu eingerichtet ist, einen jeweiligen ersten Strom und einen jeweiligen zweiten Strom in die jeweilige Wicklung ($u$, $v$, $w$; $U$, $V$, $W$) der mehreren Phasen einzuprägen, wobei sich in zumindest einer der mehreren Phasen der jeweilige eingeprägte zweite Strom von dem jeweiligen eingeprägten ersten Strom unterscheidet,
   - eine Erfassungseinrichtung (72), welche dazu eingerichtet ist, eine durch die eingeprägten ersten Ströme bzw. eine durch die eingeprägten zweiten Ströme hervorgerufene jeweilige erste Spannung bzw. zweite Spannung in den mehreren Phasen gleichzeitig zu erfassen, und
   - eine Bestimmungseinrichtung (73), welche dazu eingerichtet ist, mehrere Widerstände ($R_1$, $R_2$, $R_3$, $R_N$) in der Spannungsebene des Mehrphasen-Transformators (10) gleichzeitig in Abhängigkeit von den eingeprägten ersten Strömen und den eingeprägten zweiten Strömen sowie den erfassten ersten Spannungen und den erfassten zweiten Spannungen zu bestimmen, wobei die gleichzeitig bestimmten mehreren Widerstände ($R_1$, $R_2$, $R_3$, $R_N$) des Mehrphasen-Transformators (10) Widerstände ($R_1$, $R_2$, $R_3$) der einzelnen Phasen des Mehrphasen-Transformators (10) umfassen.

10. Vorrichtung (70) gemäß Anspruch 9, wobei die Bestimmungseinrichtung (73) ein Rechnersystem ist.

11. Vorrichtung (70) gemäß Anspruch 9 oder 10, ferner aufweisend eine Steuereinrichtung (74), welche zur vollautomatischen Bestimmung der Widerstände ($R_1$, $R_2$, $R_3$, $R_N$) ausgestaltet ist.

12. Vorrichtung (70) gemäß Anspruch 11, wobei die Bestimmungseinrichtung (73) die Steuereinrichtung (74) umfasst.

13. Vorrichtung (70) gemäß Anspruch 11 oder Anspruch 12, wobei die Steuereinrichtung (74) zur automatischen Ansteuerung der Stromquelle (71) und der Erfassungseinrichtung (72) ausgestaltet ist.

14. Vorrichtung (70) gemäß einem der Ansprüche 9 - 12, wobei die Vorrichtung (70) tragbar ausgestaltet ist.

**Claims**

1.  A method (60) for determining resistances ($R_1$, $R_2$, $R_3$, $R_N$) in a voltage level of a multiphase transformer (10), the voltage level having a winding (u, v, w; U, V, W) per phase of the multiphase transformer (10), comprising:

    - impressing a respective first current into the respective winding (u, v, w; U, V, W) of the multiple phases,
    - simultaneously detecting a respective first voltage in the plurality of phases caused by the impressed first currents,
    - impressing a respective second current in the respective winding (u, v, w; U, V, W) of the plurality of phases, wherein in at least one of the plurality of phases the respective impressed second current is different from the respective impressed first current,
    - simultaneously detecting a respective second voltage in the plurality of phases caused by the impressed second currents, and
    - simultaneously determining a plurality of resistances ($R_1$, $R_2$, $R_3$, $R_N$) in the voltage level of the multiphase transformer (10) in dependence on the impressed first currents and the impressed second currents as well as the detected first voltages and the detected second voltages, wherein the simultaneously determined plurality of resistances ($R_1$, $R_2$, $R_3$, $R_N$) of the multiphase transformer (10) comprise resistances ($R_1$, $R_2$, $R_3$) of the individual phases of the multiphase transformer (10).

2.  The method (60) according to claim 1, wherein determining the plurality of resistances ($R_1$, $R_2$, $R_3$, $R_N$) in the voltage level comprises solving a system of equations which is based on a network analysis of the voltage level at the impressed first and second currents of the plurality of phases.

3.  The method (60) according to claim 1 or 2, wherein detecting the respective voltage in the plurality of phases caused by the impressed currents comprises detecting the respective caused voltage between respective first ($u_1$, $v_1$, $w_1$; $U_1$, $V_1$, $W_1$) and second terminals ($u_2$, $v_2$, $w_2$; $u_2$, $V_2$, $W_2$) of the respective winding in the plurality of phases.

4.  The method (60) according to claim 3, wherein the voltage level comprises a star connection (20) of the plurality of windings (u, v, w; U, V, W), wherein the first terminals ($u_1$, $v_1$, $w_1$; $U_1$, $V_1$, $W_1$) of the plurality of windings (u, v, w; U, V, W) are connected to a neutral conductor (N).

5.  The method (60) according to claim 3, wherein the voltage level comprises a star connection (20) of the plurality of windings (u, v, w; U, V, W), wherein the first terminals ($u_1$, $v_1$, $w_1$; $U_1$, $V_1$, $W_1$) of the plurality of windings (u, v, w; U, V, W) are connected to a neutral conductor (N) via a feedthrough resistance ($R_N$).

6.  The method (60) according to claim 5, wherein the plurality of determined resistances comprise the feedthrough resistance ($R_N$).

7.  The method (60) according to claim 3, wherein the voltage level comprises a delta connection (50) of the plurality of windings (u, v, w; U, V, W).

8.  The method (60) according to any one of the preceding claims, wherein the determined plurality of resistances comprise the resistances ($R_1$, $R_2$, $R_3$) of the plurality of windings (u, v, w; U, V, W) of the individual phases of the multiphase transformer (10).

9.  A device (70) for determining resistances ($R_1$, $R_2$, $R_3$, $R_N$) in a voltage level of a multiphase transformer (10), wherein the voltage level has one winding (u, v, w; U, V, W) per phase of the multiphase transformer (10), comprising:

    - a current source (71) configured to impress a respective first current and a respective second current into the respective winding (u, v, w; U, V, W) of the plurality of phases, wherein in at least one of the plurality of phases the respective impressed second current is different from the respective impressed first current,
    - a detecting device (72) configured to simultaneously detect a respective first voltage and a respective second voltage in the plurality of phases caused by the impressed first currents and the impressed second currents, respectively, and
    - a determining device (73) configured to determine a plurality of resistances ($R_1$, $R_2$, $R_3$, $R_N$) in the voltage plane of the multiphase transformer (10) simultaneously in dependence on the impressed first currents and the impressed second currents as well as the detected first voltages and the detected second voltages, wherein the simultaneously determined plurality of resistances ($R_1$, $R_2$, $R_3$, $R_N$) of the multiphase transformer (10)

comprise resistances ($R_1$, $R_2$, $R_3$) of the individual phases of the multiphase transformer (10).

10. The device (70) according to claim 9, wherein the determining device (73) is a computer system.

11. The device (70) according to claim 9 or 10, further comprising a control device (74) which is configured for fully automatic determination of the resistances ($R_1$, $R_2$, $R_3$, $R_N$).

12. The device (70) according to claim 11, wherein the determining device (73) comprises the control device (74).

13. The device (70) according to claim 11 or claim 12, wherein the control device (74) is configured for automatically controlling the current source (71) and the detection device (72).

14. The device (70) according to any one of claims 9 - 12, wherein the device (70) is configured to be portable.

**Revendications**

1. Procédé (60) de détermination de résistances ($R_1$, $R_2$, $R_3$, $R_N$) dans un niveau de tension d'un transformateur polyphasé (10), dans lequel le niveau de tension présente un bobinage (u, v, w ; U, V, W) par phase du transformateur polyphasé (10), comprenant :

    - l'application d'un premier courant respectif dans le bobinage respectif (u, v, w ; U, V, W) de la pluralité de phases,
    - la détection concomitante d'une première tension respective dans la pluralité de phases, laquelle première tension est induite par les premiers courants appliqués,
    - l'application d'un second courant respectif dans le bobinage respectif (u, v, w ; U, V, W) de la pluralité de phases, dans lequel le second courant respectif appliqué dans au moins une phase de la pluralité de phases diffère du premier courant respectif appliqué,
    - la détection concomitante d'une seconde tension respective dans la pluralité de phases, laquelle seconde tension est induite par les seconds courants appliqués, et
    - la détermination concomitante de plusieurs résistances ($R_1$, $R_2$, $R_3$, $R_N$) dans le niveau de tension du transformateur polyphasé (10) en fonction des premiers courants appliqués et des seconds courants appliqués ainsi que des premières tensions détectées et des secondes tensions détectées, dans lequel la pluralité de résistances ($R_1$, $R_2$, $R_3$, $R_N$) déterminées de manière concomitante du transformateur polyphasé (10) comprennent des résistances ($R_1$, $R_2$, $R_3$) des phases individuelles du transformateur polyphasé (10).

2. Procédé (60) selon la revendication 1, dans lequel la détermination de la pluralité de résistances ($R_1$, $R_2$, $R_3$, $R_N$) dans le niveau de tension comprend une résolution d'un système d'équations, lequel repose sur une analyse de réseau du niveau de tension pour les premiers et seconds courants appliqués de la pluralité de phases.

3. Procédé (60) selon la revendication 1 ou 2, dans lequel la détection de la tension respective dans la pluralité de phases, laquelle tension respective est induite par les courants appliqués, comprend une détection de la tension respective induite entre de premières bornes ($u_1$, $v_1$, $w_1$ ; $U_1$, $V_1$, $W_1$) et de secondes bornes ($u_2$, $v_2$, $w_2$ ; $U_2$, $V_2$, $W_2$) respectives du bobinage respectif dans la pluralité de phases.

4. Procédé (60) selon la revendication 3, dans lequel le niveau de tension comprend un montage en étoile (20) de la pluralité de bobinages (u, v, w ; U, V, W), dans lequel les premières bornes ($u_1$, $v_1$, $w_1$ ; $u_1$, $V_1$, $W_1$) de la pluralité de bobinages (u, v, w ; U, V, W) sont reliées à un conducteur neutre (N).

5. Procédé (60) selon la revendication 3, dans lequel le niveau de tension comprend un montage en étoile (20) de la pluralité de bobinages (u, v, w ; U, V, W), dans lequel les premières bornes ($u_1$, $v_1$, $w_1$ ; $U_1$, $V_1$, $W_1$) de la pluralité de bobinages (u, v, w ; U, V, W) sont reliées à un conducteur neutre (N) par l'intermédiaire d'une résistance de passage ($R_N$).

6. Procédé (60) selon la revendication 5, dans lequel la pluralité de résistances déterminées comprennent la résistance de passage ($R_N$).

7. Procédé (60) selon la revendication 3, dans lequel le niveau de tension comprend un montage en triangle (50) de la pluralité de bobinages (u, v, w ; U, V, W).

**8.** Procédé (60) selon l'une des revendications précédentes, dans lequel la pluralité de résistances déterminées comprennent les résistances ($R_1$ $R_2$, $R_3$) de la pluralité de bobinages (u, v, w ; U, V, W) des phases individuelles du transformateur polyphasé (10).

**9.** Dispositif (70) de détermination de résistances ($R_1$, $R_2$, $R_3$, $R_N$) dans un niveau de tension d'un transformateur polyphasé (10), dans lequel le niveau de tension présente un bobinage (u, v, w ; U, V, W) par phase du transformateur polyphasé (10), comprenant :

- une source de courant (71), laquelle est conçue pour appliquer un premier courant respectif et un second courant respectif dans le bobinage respectif (u, v, w ; U, V, W) de la pluralité de phases, dans lequel le second courant respectif appliqué dans au moins une phase de la pluralité de phases diffère du premier courant respectif appliqué,
- un appareil de détection (72), lequel est conçu pour détecter de manière concomitante une première tension respective ou une seconde tension respective dans la pluralité de phases, lesdites tensions étant induites par les premiers courants appliqués ou par les seconds courants appliqués, et
- un appareil de détermination (73), lequel est conçu pour déterminer plusieurs résistances ($R_1$, $R_2$, $R_3$, $R_N$) dans le niveau de tension du transformateur polyphasé (10) de manière concomitante en fonction des premiers courants appliqués et des seconds courants appliqués ainsi que des premières tensions détectées et des secondes tensions détectées, dans lequel la pluralité de résistances ($R_1$, $R_2$, $R_3$, $R_N$) déterminées de manière concomitante du transformateur polyphasé (10) comprennent des résistances ($R_1$, $R_2$, $R_3$) des phases individuelles du transformateur polyphasé (10).

**10.** Dispositif (70) selon la revendication 9, dans lequel l'appareil de détermination (73) est un système informatique.

**11.** Dispositif (70) selon la revendication 9 ou 10, présentant en outre un appareil de commande (74), lequel est configuré pour la détermination entièrement automatique des résistances ($R_1$, $R_2$, $R_3$, $R_N$).

**12.** Dispositif (70) selon la revendication 11, dans lequel l'appareil de détermination (73) comprend l'appareil de commande (74).

**13.** Dispositif (70) selon la revendication 11 ou la revendication 12, dans lequel l'appareil de commande (74) est configuré pour la commande automatique de la source de courant (71) et de l'appareil de détection (72).

**14.** Dispositif (70) selon l'une des revendications 9 à 12, dans lequel le dispositif (70) est conçu pour être portable.

FIG. 1

FIG. 2

FIG. 3

FIG. 4

FIG. 5

60

```
┌─────────────────────────────┐
│    Einprägen erster Ströme   │
└─────────────────────────────┘
              │
              ▼
┌─────────────────────────────┐
│  Erfassen erster Spannungen  │
└─────────────────────────────┘
              │
              ▼
┌─────────────────────────────┐
│   Einprägen zweiter Ströme   │
└─────────────────────────────┘
              │
              ▼
┌─────────────────────────────┐
│  Erfassen zweiter Spannungen │
└─────────────────────────────┘
              │
              ▼
┌─────────────────────────────┐
│  Bestimmen von Widerständen  │
└─────────────────────────────┘
```

## FIG. 6

FIG. 7

FIG. 8

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 7106078 B1

- EP 2710389 B1